# FASCICULE DE BREVET EUROPEEN

(11) **EP 0 767 476 B1**
(45) Date de publication et mention de la délivrance du brevet: **19.12.2001**
(21) Numéro de dépôt: 96202674.6
(22) Date de dépôt: 24.09.1996
(51) Int. Cl.: H01H 13/14, B60R 11/02

(54) **Façade d'appareil électronique, munie d'un bouton poussoir**
Frontplatte für ein elektronisches Gerät, ausgerüstet mit einer Taste
Front panel for electronic apparatus, equipped with a push-button

(30) Priorité: 04.10.1995 FR 9511668
(43) Date de publication de la demande: 09.04.1997
(73) Titulaire: Mannesmann VDO Aktiengesellschaft, 60388 Frankfurt am Main (DE)
(72) Inventeur: Guilleminot, Pierre, Société Civile S.P.I.D., 75008 Paris (FR); Aubert, Bruno, Société Civile S.P.I.D., 75008 Paris (FR)

(56) Documents cités:
- EP-A- 0 566 128
- DE-A- 3 010 515
- IBM TECHNICAL DISCLOSURE BULLETIN, vol. 33, no. 10B, 1 Mars 1991, page 381/382 XP000110211 "PUSH-BUTTON STRUCTURE"

## Description

La présente invention concerne une façade détachable destinée à être appliquée sur la face avant d'un appareil électronique de loisir, dont la dite face avant porte un organe de commande qui en dépasse et est actionné par une poussée, façade munie d'un bouton coulissant qui lui est attaché et est situé de façon à être en regard de l'organe de commande lorsque la façade est montée sur l'appareil, et d'un élément élastique qui tend à repousser le bouton coulissant vers l'arrière.

Une façade munie d'un élément élastique qui tend à repousser vers l'arrière un bouton de commande d'un lecteur de cassette est connue du document DE-A-30 10 515.

Un objet de l'invention est d'améliorer la commodité d'emploi d'une façade détachable.

A cet effet, la longueur du bouton est inférieure ou pratiquement égale à l'épaisseur de la façade et la façade est munie de moyens pour faire rentrer le bouton à l'intérieur de la façade, de sorte qu'il ne dépasse plus hors de la façade, lorsque cette dernière est détachée de l'appareil.

Ainsi, si la façade est détachée, le bouton est poussé vers l'intérieur : il ne dépasse plus hors de la façade, et ne risque pas d'être accroché et endommagé lors d'un transport.

Avantageusement, l'élément élastique est un ressort en épingle, et une tige de ce ressort peut passer au travers d'un orifice transversal du bouton.

Une façade selon l'invention s'applique de manière particulièrement remarquable à un récepteur autoradio muni d'une face avant, laquelle porte une tige de commande qui en dépasse et est actionnée par une poussée.

Ces aspects de l'invention ainsi que d'autres aspects plus détaillés apparaîtront plus clairement grâce à la description suivante d'un mode de réalisation constituant un exemple non limitatif.

La figure 1 représente une portion d'un récepteur autoradio avec des éléments de l'invention, entre autres une portion d'une façade amovible.

La figure 2 représente une portion de la façade amovible du récepteur autoradio de la figure 1, retirée du récepteur, et dans laquelle un bouton coulissant est enfoncé.

Il est clair que l'invention, qui va être décrite ci-après à propos d'un récepteur autoradio à façade antivol détachable, s'applique aussi bien à tout autre type d'appareil, par exemple un appareil audio de salon.

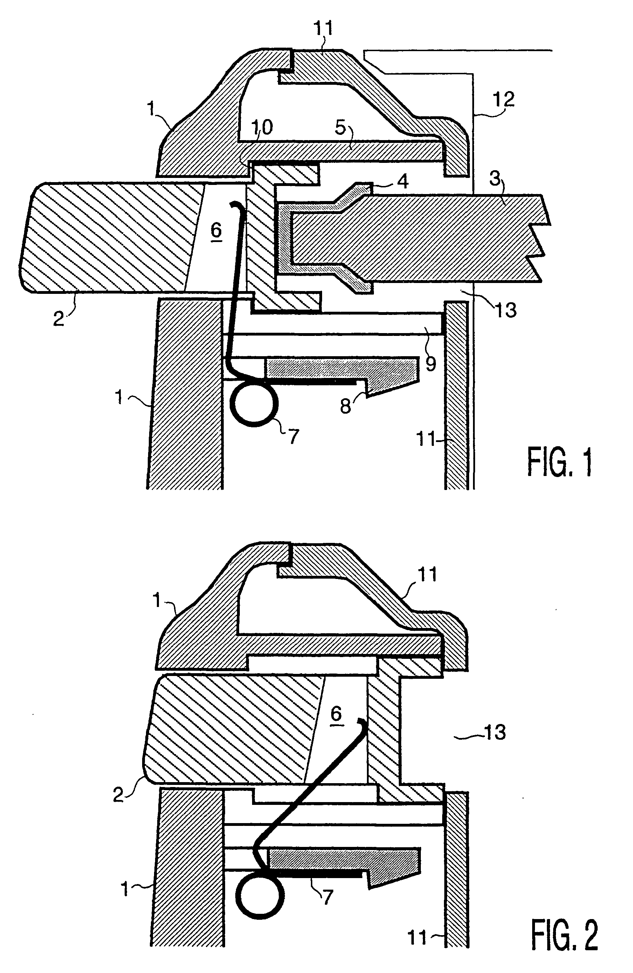

La façade amovible d'un appareil, dont une portion est représentée par la figure 1, est faite de plusieurs éléments, dont une face frontale 1 (celle que voit l'utilisateur), qui est tournée vers la gauche sur la figure, et une face arrière 11, qui est destinée à être appliquée sur au moins une partie de la face avant de l'appareil. La façade porte un bouton de commande 2 qui, sur la figure 1, fait saillie à l'avant de la façade.

Le corps du récepteur est constitué par un boîtier qui contient les éléments les plus volumineux du récepteur, dont entre autres un bloc lecteur de cassettes connu, non représenté. La face avant du corps est suggérée par une ligne 12. Elle est traversée par l'extrémité 3 d'une tige dite sabre, qui sert à commander une fonction du bloc lecteur de cassettes, par exemple l'éjection de cassette, ou le bobinage rapide. La tige 3 est métallique et son extrémité est recouverte par un capuchon 4, en matière plastique. Elle a une longueur telle que son extrémité est située vers le milieu de l'épaisseur de la façade, lorsque celle ci est en place.

Le bouton 2 est monté à coulissement dans la-façade 1. Pour assurer un maintien mécanique satisfaisant, le bouton est muni d'une partie de guidage 5, 9 qui permet le coulissement à l'intérieur de la façade dans un support, et d'un épaulement 10 qui empêche le bouton de sortir par l'avant de la façade. De multiples variantes d'un tel système de guidage sont connues de l'homme du métier. Notamment on peut imaginer que l'orifice 13 dans la face arrière 11 soit assez grand pour permettre l'introduction du bouton 2 par l'arrière, auquel cas la partie de guidage 5 pourrait comporter un système de clips pour retenir le bouton, une fois ce dernier introduit.

Le bouton 2 peut être poussé vers la droite, sur la figure 1. Il est muni d'un logement creux 6, constituant une sorte de tunnel en travers du corps du bouton, dans lequel est introduite une tige d'un ressort en épingle 7, qui est fixé par ailleurs à la façade au moyen d'un support 8. Le ressort est bandé dans un sens tel qu'il pousse le bouton vers la droite, sur la figure, c'est-à-dire qu'il l'enfonce vers la face avant du corps.

Lorsque la façade est en place, comme indiqué sur la figure 1, le bouton 2 est en face de l'extrémité de la tige-sabre 3, et lorsqu'on appuie sur le bouton, cela pousse la tige-sabre.

Lorsque la façade est enlevée, comme indiqué sur la figure 2, le bouton 2 s'enfonce dans la façade sous l'action du ressort 7, et ne fait plus saillie hors de la face frontale 1. La façade a une épaisseur qui est supérieure à la longueur du bouton, ou du même ordre de grandeur qu'elle, et ce dernier est alors à peu près entièrement contenu à l'intérieur de la façade. Le ressort est monté avec une légère précontrainte, c'est à dire qu'il reste tendu même dans la position représentée à la figure 2, afin d'empêcher des vibrations.

Différentes variantes peuvent être imaginées : dans une variante, le ressort, au lieu de posséder une tige qui passe au travers d'un orifice transversal du bouton, peut posséder deux tiges qui passent de part et d'autre du bouton en s'accrochant à des pièces en saillie sur la surface externe du bouton. Dans une autre variante, un même ressort unique peut être utilisé pour deux boutons contigus, il comporte alors un appui central et deux tiges latérales symétriques de part et d'autre de l'appui, qui pénètrent chacune dans un orifice transversal de l'un des deux boutons. Le ressort pourrait aussi être de type en hélice, et placé vis-à-vis du bouton de façon connue pour un tel ressort.

## Revendications

1. Façade détachable destinée à être appliquée sur la face avant d'un appareil électronique de loisir, dont la dite face avant porte un organe de commande qui en dépasse et est actionné par une poussée, façade munie d'un bouton coulissant (2) qui lui est attaché et est situé de façon à être en regard de l'organe de commande lorsque la façade est montée sur l'appareil, et d'un élément élastique qui tend à repousser le bouton coulissant vers l'arrière, **caractérisée en ce que** la longueur du bouton est inférieure ou pratiquement égale à l'épaisseur de la façade et la façade est munie de moyens pour faire rentrer le bouton à l'intérieur de la façade de sorte qu'il ne dépasse plus hors de la façade, lorsque cette dernière est détachée de l'appareil.

2. Façade selon la revendication 1, **caractérisée en ce que** l'élément élastique est un ressort en épingle (7).

3. Façade selon la revendication 2, **caractérisée en ce que** l'élément élastique est un ressort en épingle, dont une tige passe au travers d'un orifice transversal (6) du bouton.

4. Récepteur autoradio muni d'une face avant, laquelle porte un organe de commande qui en dépasse et est actionnée par une poussée, **caractérisé en ce qu'**il est équipé d'une façade selon l'une quelconque des revendications 1 à 3.

## Patentansprüche

1. Abnehmbare Frontplatte, die dafür bestimmt ist, auf der Vorderseite eines Unterhaltungselektronikgerätes angebracht zu werden, dessen Vorderseite ein Betätigungsorgan trägt, das daraus hervorsteht und durch eine Schubkraft betätigt wird, wobei die Frontplatte mit einem verschiebbaren Knopf (2) versehen ist, der an ihr angebracht ist und so gelegen ist, daß er gegenüber dem Betätigungsorgan liegt, wenn die Frontplatte an das Gerät montiert ist, und mit einem elastischen Element, das darauf abzielt, den verschiebbaren Knopf nach hinten zu schieben, **dadurch gekennzeichnet, daß** die Länge des Knopfes kleiner oder praktisch gleich der Dicke der Frontplatte ist und daß die Frontplatte mit Mitteln versehen ist, um den Knopf ins Innere der Frontplatte zurückkehren zu lassen, wenn die letztere von dem Gerät abgenommen wird, so daß er nicht mehr über die Frontplatte vorsteht.

2. Frontplatte nach Anspruch 1, **dadurch gekennzeichnet, daß** das elastische Element eine Schnappfeder (7) ist.

3. Frontplatte nach Anspruch 2, **dadurch gekennzeichnet, daß** das elastische Element eine Schnappfeder ist, von der ein Stift durch eine transversale Öffnung (6) des Knopfes verläuft.

4. Autoradioempfänger mit einer Vorderseite, die ein Betätigungsorgan trägt, das daraus hervorsteht und durch eine Schubkraft betätigt wird, **dadurch gekennzeichnet, daß** es mit einer Frontplatte nach einem der Ansprüche 1 bis 3 versehen ist.

## Claims

1. Detachable front panel intended to be applied to the front face of a leisure electronics apparatus, the said front face of which carries a control member which protrudes from it and is actuated by pushing, the front panel being equipped with a sliding button (2) which is attached to it and is situated in such a way as to face the control member when the front panel is mounted on the apparatus, and with an elastic element which tends to push the sliding button back, **characterized in that** the length of the button is less than or practically equal to the thickness of the front panel and the front panel is equipped with means for causing the button to be housed inside the front panel so that it no longer protrudes from the front panel when the latter is detached from the apparatus.

2. Front panel according to Claim 1, **characterized in that** the elastic element is a hair pin spring (7).

3. Front panel according to Claim 2, **characterized in that** the elastic element is a hair pin spring, one leg of which passes through a transverse orifice (6) of the button.

4. Car radio receiver equipped with a front face, which carries a control member which protrudes from it and is actuated by pushing, **characterized in that** it is equipped with a front panel according to any one of Claims 1 to 3.
